# EUROPÄISCHE PATENTSCHRIFT

(11) **EP 2 737 516 B1**
(45) Veröffentlichungstag und Bekanntmachung des Hinweises auf die Patenterteilung: **03.06.2015**
(21) Anmeldenummer: 12769007.1
(22) Anmeldetag: 25.07.2012
(51) Int. Cl.: H01J 37/32

(54) **VERFAHREN UND VORRICHTUNG ZUM SCHUTZ VON AN EINEN HOCHFREQUENZGENERATOR ANGESCHLOSSENEN PASSIVEN KOMPONENTEN**
METHOD AND APPARATUS FOR PROTECTING PASSIVE COMPONENTS CONNECTED TO A RADIO-FREQUENCY GENERATOR
PROCÉDÉ ET DISPOSITIF DE PROTECTION DE COMPOSANTS PASSIFS CONNECTÉS À UN GÉNÉRATEUR HAUTE FRÉQUENCE

(30) Priorität: 28.07.2011 DE 102011080035
(43) Veröffentlichungstag der Anmeldung: 04.06.2014
(73) Patentinhaber: TRUMPF Hüttinger GmbH + Co. KG, 79111 Freiburg im Breisgau (DE)
(72) Erfinder: FRITSCH, Christian, 79183 Waldkirch (DE); MANN, Ekkehard, 79194 Gundelfingen (DE); SEIFERT, Gerhard, 79263 Simonswald (DE)
(86) Internationale Anmeldenummer: PCT/DE2012/100223
(87) Internationale Veröffentlichungsnummer: WO 2013/013669

(56) Entgegenhaltungen:
- US-A1- 2011 148 519
- US-B1- 6 313 584

## Beschreibung

Die Erfindung betrifft ein Verfahren zum Schutz von an einen Hochfrequenzgenerator angeschlossenen passiven Komponenten. Außerdem betrifft die Erfindung einen Hochfrequenzgenerator mit einer ein Hochfrequenzleistungssignal bei einer Grundfrequenz erzeugenden HF-Quelle und einem ersten Regelkreis, dem ein mit einer über ein Hochfrequenzkabel zwischen dem Hochfrequenzgenerator und einer Last übertragenen HF-Leistung in Beziehung stehendes Signal zugeführt ist.

Hochfrequenzkabel, insbesondere Koaxialkabel, werden verwendet, um eine bei einer Grundfrequenz (auch Arbeitsfrequenz genannt) erzeugte hochfrequente Leistung von einem Hochfrequenzgenerator zu einem Anpassungsnetzwerk (Matchbox) zu übertragen. Vom Anpassungsnetzwerk aus wird die hochfrequente Leistung an eine Last, beispielsweise eine Plasmakammer, übertragen. Gelingt es dem Anpassungsnetzwerk nicht, den Ausgangswiderstand des Hochfrequenzgenerators an den Lastwiderstand anzupassen, so wird ein Teil der Leistung aufgrund der Fehlanpassung an der Last reflektiert. Dabei entsteht Leistung bei harmonischen Frequenzen der Grundfrequenz. Leistung bei diesen Frequenzen gelangt durch das Anpassungsnetzwerk und das Hochfrequenzkabel zum Hochfrequenzgenerator.

Bei den harmonischen Frequenzen verhalten sich die Last (das Plasma), eine Elektrode, das Anpassungsnetzwerk, das Hochfrequenzkabel und eine Ausgangsschaltung des Hochfrequenzgenerators wie Reaktanzelemente mit hoher Eigengüte. Die Anregung durch die Harmonischen, die durch die Reflexion an der Last verursacht werden (z.B. 100W Wirkleistung der Harmonischen bei 10kW Leistung bei der Arbeitsfrequenz), kann daher Resonanzen mit einer hohen Blindleistung (z.B. 10kVA) bewirken. Diese Blindleistung stellt eine zusätzliche Belastung für das Hochfrequenzkabel zwischen Hochfrequenzgenerator und Anpassungsnetzwerk dar. Diese Problematik gilt in besonderer Weise für so genannte Dual Frequency Anlagen, da hier besonders viele Reaktanzelemente (zwei Hochfrequenzgeneratoren, HF- Kabel sowie Impedanzanpassungsnetzwerke mit Filtern) vorliegen. Die Belastung des Hochfrequenzkabels mit Blindleistung kann zu Ausfällen des Hochfrequenzkabels führen.

US20110148519 beschreibt einen Leistungsregelung für einen Leistungsverstärker, die verschiedene Betriebsbedingungen überwacht und die Ausgangsleistung des Verstärkers regelt, indem er koordiniert sowohl die Eingangstreiberpegel für den Leistungsverstärker als auch die Verstärkung des Leistungsverstärkers steuert. Ziel der Leistungsregelung besteht darin ein optimales Ausgangssignal für ein mobiles Telefongerät zu erzielen. Um den Leistungsverstärker selbst nicht übermäßig zu belasten, wird vorgeschlagen, zusätzlich den maximalen Strom des Leistungsverstärkers zu überwachen und zu begrenzen.

US6313584 beschreibt ein System mit mehreren Impedanzanpassungsnetzwerken, die von einer Steuerung überwacht werden. Die Impedanzanpassungsnetzwerke weisen zudem Vorrichtungen zur Überwachung von Komponenten auf, die einstellbar sind, wie etwa variable Kapazitäten oder Induktivitäten, um diese vor Schäden zu bewahren.

Aufgabe der vorliegenden Erfindung ist es daher, ein Verfahren und ein Hochfrequenzgenerator bereit zu stellen, mit denen die oben genannten Probleme vermieden werden können.

Gelöst wird diese Aufgabe durch ein Verfahren zum Schutz von an einen Hochfrequenzgenerator angeschlossenen passiven Komponenten, insbesondere eines Hochfrequenzkabels, mit den Verfahrensschritten:
a. Erzeugen einer Hochfrequenzleistung bei einer Grundfrequenz mittels des Hochfrequenzgenerators;
b. Übertragen der Hochfrequenzleistung an eine Last über ein Hochfrequenzkabel;
c. Ermitteln einer mit der Hochfrequenzbelastung, insbesondere bei zumindest einer von der Grundfrequenz abweichenden Frequenz, zumindest einer an den Hochfrequenzgenerator angeschlossenen passiven Komponente, insbesondere eines Hochfrequenzkabels, in Beziehung stehenden Größe;
d. Vergleich der ermittelten Größe mit einer die maximale Belastung (maximal zulässige Belastung) zumindest einer angeschlossenen passiven Komponente beschreibenden Referenzgröße
e. Anpassung der vom Hochfrequenzgenerator bei der Grundfrequenz erzeugten Hochfrequenzleistung in Abhängigkeit von dem Vergleichsergebnis.

Dadurch, dass die übertragene Hochfrequenzleistung bzw. eine Größe, die mit der Hochfrequenzbelastung einer passiven Komponente, insbesondere des Hochfrequenzkabel (HF-Kabels), in Beziehung steht, erfasst wird, kann die Generatorleistung reduziert werden, um eine Überlastung der passiven Komponente(n), insbesondere des Hochfrequenzkabels, zu verhindern. Somit kann eine Steuerung oder Regelung der vom Hochfrequenzgenerator erzeugten Leistung bei der Grundfrequenz in Abhängigkeit davon erfolgen, welche Hochfrequenzbelastung der passiven Komponente, insbesondere des HF-Kabels, erfasst wurde. Die übertragene Hochfrequenzleistung bzw. eine damit in Beziehung stehende Größe, kann bei der Grundfrequenz und/oder bei einer oder mehreren davon abweichenden Frequenzen ermittelt werden. Passive Komponenten können beispielsweise Hochfrequenzkabel, Anschlusselemente (Stecker), Messeinrichtungen, Elektroden, Plasmakammer, etc. sein. Anwendung findet das Verfahren vorzugsweise, wenn HF-Leistung bei Grundfrequenzen im Bereich 1 - 100MHz und Leistungen im Bereich 1kW - 100kW erzeugt wird und in Systemen zur Plasmaerzeugung und Laseranregung.

Die vom Hochfrequenzgenerator bei der Grundfrequenz erzeugte Hochfrequenzleistung kann in Abhängigkeit von dem Vergleichsergebnis gesteuert oder insbesondere geregelt werden. Somit ist nicht nur eine Steuerung sondern auch eine Regelung möglich. Insbesondere kann eine Begrenzungsregelung durchgeführt werden.

Weiterhin kann eine mit der über das Hochfrequenzkabel bei der Grundfrequenz übertragenen Hochfrequenzleistung in Beziehung stehende Größe ermittelt werden, die ermittelte Größe mit einem Sollwert der Hochfrequenzleistung verglichen werden und die vom Hochfrequenzgenerator bei der Grundfrequenz erzeugte Hochfrequenzleistung in Abhängigkeit von dem Vergleichsergebnis angepasst werden. Demnach kann die Anpassung der vom Hochfrequenzgenerator erzeugten Hochfrequenzleistung bei der Grundfrequenz nach zwei Kriterien erfolgen. Zum einen kann darauf geachtet werden, dass die Hochfrequenzbelastung der passiven Komponente(n), insbesondere des Hochfrequenzkabels, nicht zu groß wird. Zum anderen kann die Leistung erfasst werden, die einer Last zur Verfügung gestellt wird und die erzeugte Leistung entsprechend angepasst werden, um einen Sollwert für die der Last bei der Grundfrequenz zugeführte Leistung möglichst gut zu erreichen. Insbesondere kann auf eine Sollleistung geregelt werden. Dabei kann für die Anpassung der vom Hochfrequenzgenerator bei der Grundfrequenz erzeugten Hochfrequenzleistung dasjenige Vergleichsergebnis verwendet werden, das zu einer stärkeren Reduzierung der Hochfrequenzleistung führt. Somit wird zum einen einer Überlastung der passiven Komponente(n), insbesondere des Hochfrequenzkabels, wirksam begegnet und zum anderen verhindert, dass der Last zu viel Leistung zugeführt wird.

Die bei von der Grundfrequenz abweichenden Frequenzen über das Hochfrequenzkabel übertragene Leistung kann ermittelt werden. Wenn die bei von der Grundfrequenz abweichenden Frequenzen übertragene Leistung oder eine damit in Beziehung stehende Größe ermittelt wird, so kann besonders einfach die Hochfrequenzbelastung des Hochfrequenzkabels bzw. der passiven Komponente(n) ermittelt werden. Insbesondere kann die Belastung durch Harmonische ermittelt werden.

Weiterhin kann vorgesehen sein, dass die gesamte über das Hochfrequenzkabel in eine Richtung übertragene Leistung ermittelt wird. Dabei kann entweder die gesamte Leistung, die in Vorwärtsrichtung, d.h. vom Hochfrequenzgenerator zur Last übermittelte Leistung oder die an der Last reflektierte Leistung ermittelt werden. Es ist auch denkbar, für jede Richtung zu ermitteln, welche Leistung übertragen wird.

Weiterhin kann die bei der Grundfrequenz über das Hochfrequenzkabel in eine Richtung übertragene Leistung ermittelt werden. Wenn die bei der Grundfrequenz in eine Richtung übertragene Leistung ermittelt wird und die gesamte in eine Richtung übertragene Leistung ermittelt wird, kann durch Differenzbildung herausgefunden werden, welche Hochfrequenzbelastung durch von der Grundfrequenz abweichende Frequenzen, beispielsweise Harmonische oder Frequenzen unterhalb der Grundfrequenz, verursacht wird.

Zur Überwachung eines Hochfrequenzgenerators kann es vorteilhaft sein, wenn die gesamte und/oder die bei den von der Grundfrequenz abweichenden Frequenzen über das Hochfrequenzkabel in Richtung Last übertragene Leistung angezeigt wird. Die angezeigte Leistung bzw. die angezeigte Belastung des Hochfrequenzkabels kann als Bezugsfrequenz die Grundfrequenz verwenden.

Gemäß einer Verfahrensvariante kann vorgesehen sein, dass ein mit der über das Hochfrequenzkabel übertragenen Leistung in Beziehung stehendes Signal mit einem breitbandigen Bandpassfilter gefiltert wird. Dadurch ist es insbesondere möglich, die Leistung bei Oberwellen zu ermitteln. Die Filterung kann im Bereich 1 - 200 MHz erfolgen.

Dabei kann der Bandpassfilter mit einem Korrekturfrequenzgang modifiziert werden. Hochfrequenzkabel weisen je nach Frequenz eine unterschiedliche Belastbarkeit auf. Wenn Oberwellen bei verschiedenen Frequenzen auftreten, können durch einen Korrekturfrequenzgang beispielsweise höhere Frequenzen stärker bewertet werden, um so eine genauere Aussage über die Belastung des Hochfrequenzkabels zu erzielen. Insbesondere kann dadurch berücksichtigt werden, dass die Kabelbelastbarkeit bei Fehlanpassung niedriger ist als die im Datenblatt für das Hochfrequenzkabel angegebene Belastbarkeit.

Weiterhin kann vorgesehen sein, dass die Hochfrequenzbelastung des Hochfrequenzkabels bzw. der passiven Komponente(n) anhand der vom Hochfrequenzgenerator in Richtung Last gelieferten Vorwärtsleistung oder anhand der reflektierten Leistung ermittelt wird. Beispielsweise kann in dem Fall, in dem ein Hochfrequenzgenerator für alle Frequenzen einen hohen Reflektionsfaktor aufweist und die Last für alle Frequenzen, außer der Grundfrequenz, einen hohen Reflektionsfaktor aufweist, lediglich die reflektierte Leistung betrachtet werden. Dies deshalb, da für jede Oberwellenfrequenz gilt, dass die Vorwärtsleistung gleich der reflektierten Leistung ist.

Weist jedoch der Hochfrequenzgenerator für alle Frequenzen oder alle Frequenzen außer der Grundfrequenz einen niedrigen Reflektionsfaktor auf und weist die Last für alle Frequenzen außer der Grundfrequenz einen hohen Reflektionsfaktor auf, werden alle von der Last kommenden Oberwellen im Generator absorbiert. Zur Messung der Oberwellenleistung sowie zur Kabelbelastung ist die Auswertung der Vorwärtsleistung und der reflektierten Leistung notwendig.

Gemäß einer Verfahrensvariante kann vorgesehen sein, dass die Hochfrequenzbelastung mehrerer Hochfrequenzkabel bzw. passiver Komponenten, über die jeweils ein Hochfrequenzgenerator mit der Last verbunden ist, ermittelt wird und wenn eine Hochfrequenzbelastung einen vorgegebenen Wert übersteigt, die bei der jeweiligen Grundfrequenz erzeugte Hochfrequenzleistung aller an die Last angeschlossener HF-Generatoren reduziert wird.

Die die maximale Belastung (maximal zulässige Belastung) einer passiven Komponente beschreibende Referenzgröße kann eingestellt werden. Dadurch kann eine Anpassung auf die jeweils eingesetzten passiven Komponenten erfolgen.

Weiterhin kann die die maximale Belastung beschreibende Referenzgröße aus einem Katalog von vorgegebenen Eigenschaften zumindest einer passiven Komponente und/oder zumindest einer aktiven an die Plasmakammer angeschlossenen Komponente bestimmt werden. Beispielsweise kann ein Hersteller für eine passive Komponente eine oder mehrere Kenngrößen angeben, aus denen dann die Referenzgröße ermittelt wird, also z.B. ausgewählt oder berechnet wird. Aktive an die Plasmakammer angeschlossene Komponenten können z.B. Anpassungsnetzwerke (Matchboxen) oder Hochfrequenzgeneratoren sein.

Alternativ oder zusätzlich kann die die maximale Belastung beschreibende Referenzgröße automatisch eingestellt werden. Die automatische Einstellung kann beispielsweise in Abhängigkeit von einer automatischen Erkennung angeschlossener passiver Komponenten, wie Hochfrequenzkabel, oder anderer Hochfrequenzgeneratoren, die bei anderen Frequenzen arbeiten können, erfolgen.

In den Rahmen der Erfindung fällt außerdem ein Hochfrequenzgenerator mit einer ein Hochfrequenzleistungssignal bei einer Grundfrequenz erzeugenden HF-Quelle und einem ersten Regelkreis, dem ein mit einer über ein Hochfrequenzkabel zwischen dem Hochfrequenzgenerator und einer Last übertragenen HF-Leistung in Beziehung stehendes Signal zugeführt ist, wobei der Regelkreis einen Regler zur Regelung der HF-Quelle basierend auf einem diesem zugeführten Sollwert für die HF-Belastung, insbesondere HF-Kabelbelastung, insbesondere einem Maximalwert, als Referenzwert und der übertragenen HF-Leistung aufweist. Mit einem solchen Hochfrequenzgenerator kann demnach die Ausgangsleistung des Hochfrequenzgenerators bei der Grundfrequenz in Abhängigkeit von der (Kabel-)Belastung geregelt werden. Es ist somit nicht nur eine Regelung der Ausgangsleistung auf einen Sollwert für die Ausgangsleistung möglich.

Der Regelkreis kann einen breitbandigen Bandpassfilter aufweisen. Mit einem solchen Bandpassfilter ist es möglich, die bei den Oberwellen übertragene Leistung zu ermitteln. Insbesondere kann der Filter auf ein Frequenzband im Bereich 1 - 200 MHz abgestimmt sein.

Der Bandpassfilter kann einen Korrekturfrequenzgang aufweisen. Dadurch kann berücksichtigt werden, dass die Kabelbelastbarkeit sich auf den 50Ω-Lastfall bezieht, für Oberwellen jedoch ein Reflektionsfaktor von 1 vorliegt.

Weiterhin kann ein zweiter Regelkreis vorgesehen sein, dem ein mit einer über ein Hochfrequenzkabel zwischen dem Hochfrequenzgenerator und einer Last übertragenen HF-Leistung in Beziehung stehendes Signal zugeführt ist. Der Regelkreis weist einen Regler zur Regelung der HF-Quelle basierend auf einem diesem zugeführten Sollwert für die vom Hochfrequenzgenerator auszugebende Hochfrequenzleistung bei der Grundfrequenz und der übertragenen HF-Leistung auf. Somit ist es auch möglich, auf einen Sollwert für die Hochfrequenzleistung zu regeln.

Der zweite Regelkreis kann einen auf die Grundfrequenz abgestimmten Filter aufweisen. Dadurch ist es möglich, die bei der Grundfrequenz an die Last gelieferte Leistung bzw. die bei der Grundfrequenz reflektierte Leistung zu erfassen.

Die Regler können über eine Vorrangschaltung mit der HF-Quelle verbunden sein. Dabei kann die Vorrangschaltung als Begrenzungsregler ausgeführt sein. Alternativ ist es möglich, die Vorrangschaltung als digitalen Regler auszugestalten. Insbesondere kann dadurch erreicht werden, dass derjenige Regelkreis für die Regelung der Hochfrequenzquelle Vorrang bekommt, der eine stärkere Reduzierung der von der HF-Quelle erzeugten HF-Leistung bei der Grundfrequenz bewirkt.

Weiterhin können Mittel zum Bestimmen der über das HF-Kabel übertragenen Oberwellenleistung vorgesehen sein. Somit kann ermittelt werden, welchen Anteil an der (Kabel-)Belastung die Oberwellenleistung ausmacht.

Zudem können Mittel zum Bestimmen der über das HF-Kabel übertragenen Hochfrequenzleistung vorgesehen sein. Insbesondere kann dadurch die gesamte über das HF-Kabel übertragene Leistung ermittelt werden.

Es können eine oder mehrere Anzeigeeinrichtungen zur Anzeige der über das HF-Kabel übertragenen Oberwellenleistung und/oder der über das HF-Kabel übertragenen Hochfrequenzleistung vorgesehen sein. Dadurch kann ein Bediener unmittelbar Informationen über die Hochfrequenzbelastung des HF-Kabels bzw. weiterer passiver Komponente(n) bekommen.

In den Rahmen der Erfindung fällt außerdem eine Leistungsversorgungsanordnung mit einem erfindungsgemäßen Hochfrequenzgenerator, der über ein Hochfrequenzkabel an eine Last angeschlossen ist. Weiterhin kann zumindest ein weiterer Hochfrequenzgenerator über ein Hochfrequenzkabel an die Last angeschlossen sein. Dadurch entsteht eine so genannte Dual Frequency Anlage, wobei diese Anlage aufgrund des erfindungsgemäßen Hochfrequenzgenerators davor geschützt ist, dass Hochfrequenzkabel ausfallen.

Zur Ermittlung der Vorwärtsleistung oder der reflektierten Leistung kann ein Richtkoppler vorgesehen sein. Dabei kann vorgesehen sein, dass der Richtkoppler einen festen Koppelfaktor aufweist. Der Richtkoppler ist vorzugsweise am Hochfrequenzausgang des Hochfrequenzgenerators angeordnet. Der Richtkoppler kann extern vorgesehen sein oder Bestandteil des Hochfrequenzgenerators sein. Alternativ zur Verwendung eines Richtkopplers kann eine Strom- oder Spannungsmessung durchgeführt werden, um die Kabelbelastung zu ermitteln.

Die Leistungsversorgungsanordnung kann einen ersten und einen zweiten Hochfrequenzgenerator aufweisen.

Bei der Leistungsversorgungsanordnung kann der erste Hochfrequenzgenerator ein Hochfrequenzleistungssignal bei einer ersten Grundfrequenz insbesondere von 3,39 MHz, und der zweite Hochfrequenzgenerator ein Hochfrequenzleistungssignal bei einer zweiten Frequenz insbesondere von 13,56 MHz erzeugen.

Beide Hochfrequenzgeneratoren können jeweils über Hochfrequenzkabel, mit Impedanzanpassungsgliedern verbunden sein, die wiederum gemeinsam an eine Elektrode einer Plasmakammer angeschlossen sind.

Die Hochfrequenzgeneratoren können jeweils einen wie oben beschriebenen ersten Regelkreis aufweisen.

Die Last kann als eine Plasmaanlage ausgebildet sein.

Weitere Merkmale und Vorteile der Erfindung ergeben sich aus der nachfolgenden detaillierten Beschreibung von Ausführungsbeispielen der Erfindung, anhand der Figuren der Zeichnung, die erfindungswesentliche Einzelheiten zeigen, sowie aus den Ansprüchen. Die dort gezeigten Merkmale sind derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung sind Ausführungsbeispiele der Erfindung dargestellt und in der nachfolgenden Beschreibung näher erläutert.

Es zeigen:
- Fig. 1: eine erste Ausführungsform einer Leistungsversorgungsanordnung;
- Fig. 2: eine zweite Ausführungsform einer Leistungsversorgungsanordnung;
- Fig. 3: eine schematische Darstellung einer Dual Frequency Anlage.

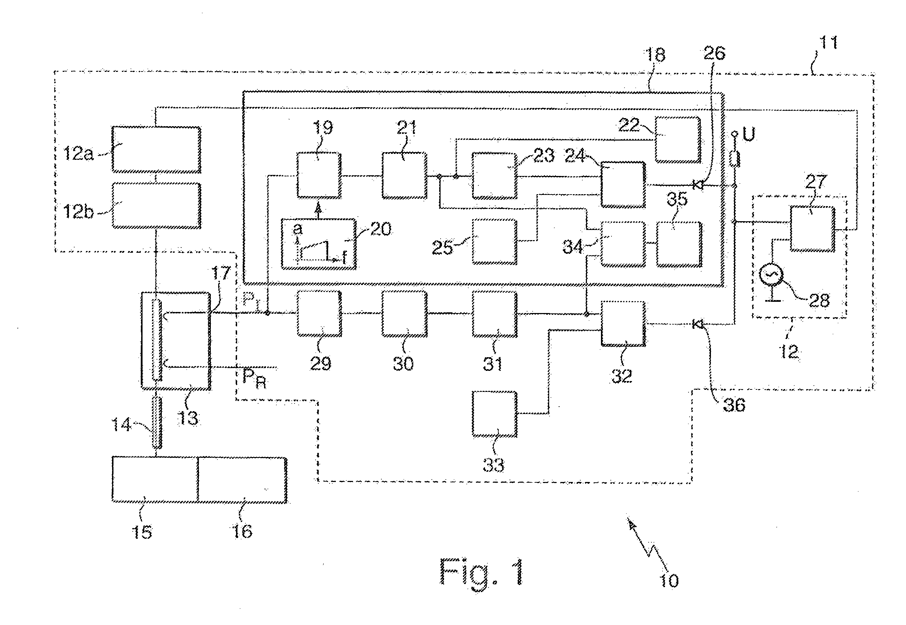

Die Figur 1 zeigt eine Leistungsversorgungsanordnung 10. Die Leistungsversorgungsanordnung 10 weist einen Hochfrequenzgenerator 11 auf, der eine Hochfrequenzquelle 12 und eine HF-Treiberstufe 12a sowie eine HF-Endstufe 12b als Ausgangsschaltung umfasst. An den Ausgang des Hochfrequenzgenerators 11 ist eine als Richtkoppler ausgebildete Messeinrichtung 13 angeschlossen. Von dort erstreckt sich ein Hochfrequenzkabel 14 zu einem Impedanzanpassungsnetzwerk 15, welches wiederum an eine als Plasmaanlage ausgebildete Last 16 angeschlossen ist.

Bei der Ausgestaltung der Leistungsversorgungsanordnung 10 gemäß der Figur 1 wird angenommen, dass der Hochfrequenzgenerator 11 für alle Frequenzen einen hohen Reflektionsfaktor aufweist. Außerdem wird angenommen, dass die Last 16 für alle Frequenzen außer der Grundfrequenz einen hohen Reflektionsfaktor aufweist. In diesem Fall gilt für jede Oberwellenamplitude, dass die Vorwärtsleistung P_{I} gleich der reflektierten Leistung P_{R} ist. Dies bedeutet, dass für die Messung der Oberwellenleistung sowie der Kabelbelastung nur die Vorwärtsleistung, die hiermit mit P_{I} bezeichnet ist, betrachtet werden muss. Unter Vorwärtsleistung versteht man die Leistung, die vom Hochfrequenzgenerator 11 in Richtung der Last 16 geleitet wird.

Am Ausgang 17 der Messeinrichtung 13 erhält man demnach ein Signal zum Beispiel im Bereich zwischen 0 und 1W, welches sowohl die Grundfrequenz, bei der durch den Hochfrequenzgenerator 11 ein HF-Leistungssignal generiert wird, als auch andere Frequenzen, zum Beispiel Oberwellen, aufweist. Dieses Signal wird einem Regelkreis 18 zugeführt und dort insbesondere einem breitbandigen Bandpassfilter 19. Der Bandpassfilter 19 kann Frequenzen im Bereich 1 bis 200 MHz filtern. Der Bandpassfilter 19 wird durch einen Korrekturfrequenzgang 20 der Kabelbelastbarkeit beeinflusst.

Das gefilterte Signal wird einem Detektor 21 zugeleitet, der aus dem gefilterten Signal ein Gleichspannungssignal generiert, welches ein Maß für den Ist-Wert der gesamten Hochfrequenzleistung, die über das HF-Kabel 14 zur Last 16 übertragen wird, darstellt. Somit kann auf der Anzeigeeinrichtung 22 ein Ist-Wert der HF-Kabelleistung angezeigt werden.

Das Ausgangssignal des Detektors 21 wird im Inverter 23 invertiert und das invertierte Signal einem Summenregler 24 zugeführt. Dem Regler 24 wird außerdem der Sollwert der HF-Kabelleistung 25 als Referenzgröße zugeführt. Da der Inverter 23 das Maß für die Ist-Leistung invertiert, wird im Regler 24 tatsächlich die Ist-Leistung von dem Sollwert der HF-Kabelleistung 25 subtrahiert und nachfolgend bestimmt, ob die Ist-Leistung den Sollwert übersteigt.

Der Regler 24 ist über einen Begrenzungsregler 26 mit einem Mischer 27 der HF-Quelle 12 verbunden. An den Mischer 27 ist außerdem ein Hochfrequenzoszillator 28 angeschlossen. Wenn der Regler 24 nun ermittelt, dass der Ist-Wert der HF-Kabelleistung den Sollwert der HF-Kabelleistung übersteigt, so wird der Mischer 27 derart angesteuert, dass die vom HF-Generator 11 bei der Grundfrequenz ausgegebene Hochfrequenzleistung reduziert wird.

Das Signal am Ausgang 17 wird weiterhin einem Bandpassfilter 29, der auf die Grundfrequenz abgestimmt ist, also schmalbandig ist, zugeführt. Das gefilterte Signal, welches nur noch mit der Leistung bei der Grundfrequenz ohne Oberwellen in Beziehung steht, wird einem Detektor 30 zugeführt, der daraus ein Gleichspannungssignal generiert, welches ein Maß für den Ist-Wert der Hochfrequenzleistung bei der Grundfrequenz ohne Oberwellen angibt. Dieses Signal wird durch den Inverter 31 invertiert und einem Regler 32, der als Summenregler ausgebildet ist, zugeführt. Dem Regler 32 ist außerdem der Sollwert der Hochfrequenzleistung 33 bei der Grundfrequenz zugeführt.

Das Ausgangssignal des Reglers 32 wird über den Begrenzungsregler 36 dem Mischer 27 zugeführt. Die Begrenzungsregler 26, 36 bewirken, dass der Ausgangswert desjenigen Reglers 24, 32 die Ausgangsleistung des Hochfrequenzgenerators 11 beeinflusst, der eine stärkere Reduzierung der bei der Grundfrequenz erzeugten Hochfrequenzleistung bewirkt. Zur korrekten Funktion ist noch ein Spannungssignal vorgesehen, das über eine Spannungsversorgung U und einen strombegrenzenden Widerstand angeschlossen ist. Die Regler 24, 32 nehmen im Wesentlichen einen Vergleich vor. Statt der Regler 24, 32 könnten auch Vergleichsglieder verwendet werden. In diesem Fall müssten die Ausgangssignale der Detektoren 21, 30 nicht invertiert werden. Die Invertierung wird durchgeführt, damit in den Reglern 24, 32 eine Abweichung von einem Sollwert bzw. Referenzwert ermittelt werden kann.

Im Summierglied 34 wird das invertierte Ausgangssignal des Detektors 30 zum Ausgangssignal des Detektors 21 addiert. Dies bedeutet, dass das Maß für die Leistung bei der Grundfrequenz von dem Maß der Gesamtleistung subtrahiert wird. Das Ergebnis ist der Ist-Wert der Leistung bzw. eine damit in Beziehung stehende Größe bei Frequenzen, die von der Grundfrequenz abweichen, insbesondere der Oberwellenleistung, die auf der Anzeigeeinrichtung 35 dann angezeigt wird.

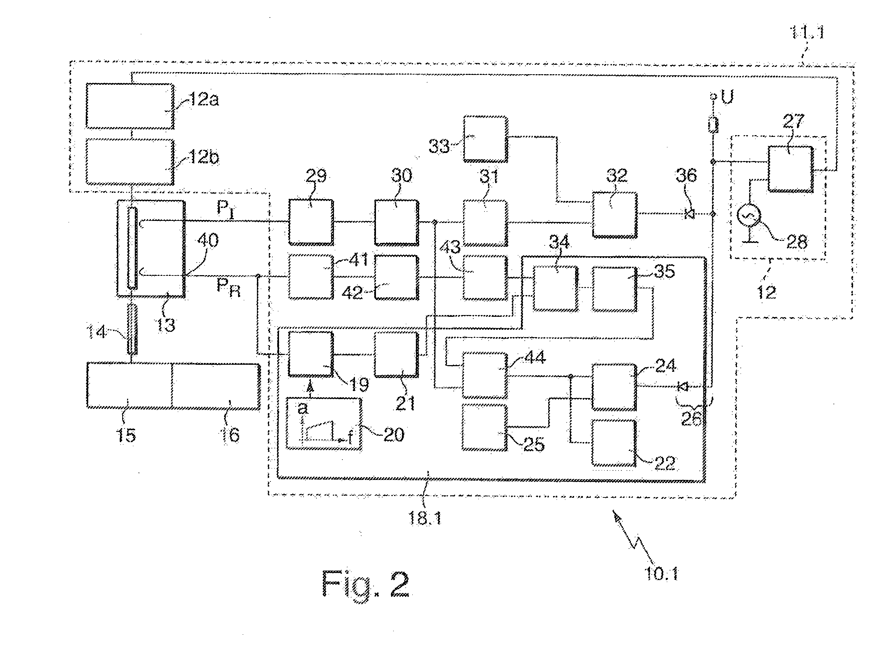

In der Figur 2 ist eine Ausführungsform einer Leistungsversorgungsanordnung 10.1 gezeigt, bei der der Hochfrequenzgenerator 11.1 für alle Frequenzen oder für alle Frequenzen außer der Grundfrequenz einen niedrigeren Reflektionsfaktor aufweist. Die Last weist für alle Frequenzen außer der Grundfrequenz einen hohen Reflektionsfaktor auf. In diesem Fall ist zur Messung der Oberwellenleistung sowie der Kabelbelastung die Auswertung der Vorwärtsleistung P_{I} und der reflektierten Leistung P_{R} am HF-Ausgang des Hochfrequenzgenerators 11.1 erforderlich. Elemente, die denen der Figur 1 entsprechen, tragen in der Figur 2 dieselben Bezugsziffern.

Es ist zu erkennen, dass der Regelkreis 18.1 nun an den Ausgang 40 der Messeinrichtung 13 angeschlossen ist. Weiterhin ist an den Ausgang 40 ein schmalbandiger Bandpassfilter 41 angeschlossen, der auf die Grundfrequenz abgestimmt ist. Hier wird eine mit der reflektierten Leistung bei der Grundfrequenz in Beziehung stehende Größe ermittelt. Das Ausgangssignal des Bandpassfilters 41 wird einem Detektor 42 zugeführt, dessen Ausgangssignal ein Gleichspannungssignal ist, welches im Inverter 43 invertiert wird. Anders als in der Figur 1 wird nun nicht das Ausgangssignal des Inverters 31 sondern das Ausgangssignal des Inverters 43 dem Summierglied 34 zugeführt. Das Ausganssignal des Summierglieds 34 ist wiederum ein Maß für den Ist-Wert der Oberwellenleistung, die auf der Anzeigeeinrichtung 35 angezeigt wird.

Der Regelkreis 18.1 weist keinen Inverter 23 mehr auf. Dafür ist ein weiteres Summierglied 44 vorgesehen, dem der Ist-Wert der reflektierten Oberwellenleistung (bzw. eine damit in Beziehung stehende Größe) und der Ist-Wert der Vorwärtsleistung bei der Grundfrequenz, d.h. das Ausgangssignal des Detektors 30, zugeführt ist. Das Ergebnis, welches am Ausgang des Summiergliedes 44 ausgegeben wird, entspricht dem Ist-Wert der Hochfrequenzkabelleistung. Dieses Signal ist außerdem dem Regler 24 zugeführt.

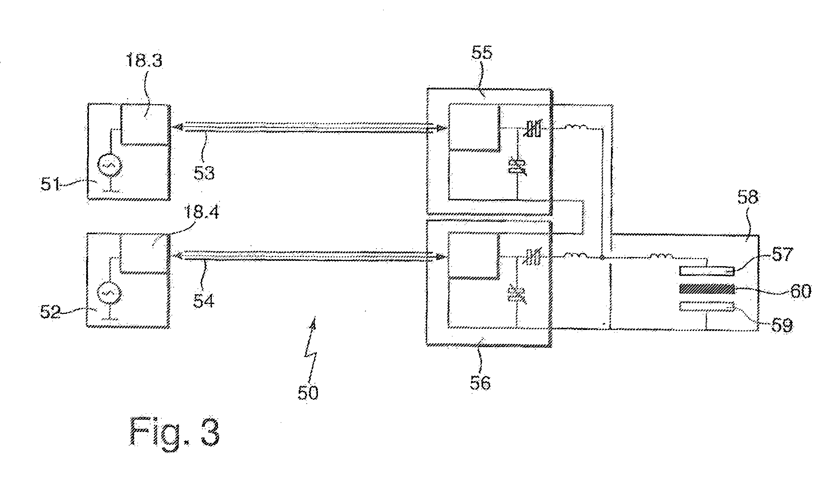

In der Figur 3 ist eine Leistungsversorgungsanordnung in Form einer so genannten Dual Frequency Anlage 50 dargestellt. Diese weist einen ersten Hochfrequenzgenerator 51 und einen zweiten Hochfrequenzgenerator 52 auf. Der Hochfrequenzgenerator 51 erzeugt beispielsweise ein Hochfrequenzleistungssignal bei einer Grundfrequenz von 3,39 MHz, während der Hochfrequenzgenerator 52 beispielsweise ein Hochfrequenzleistungssignal bei einer Frequenz von 13,56 MHz erzeugt. Beide Hochfrequenzgeneratoren 51, 52 sind jeweils über Hochfrequenzkabel 53, 54 mit Impedanzanpassungsgliedern 55, 56 verbunden, die wiederum gemeinsam an eine Elektrode 57 einer Plasmakammer 58 angeschlossen sind. In der Plasmakammer 58 befindet sich eine Gegenelektrode 59, die an Masse angeschlossen ist. Zwischen der Elektrode 57 und der Gegenelektrode 59 wird ein Plasma 60 generiert. Die Hochfrequenzgeneratoren 51, 52 weisen jeweils einen Regelkreis 18.3, 18.4 der in Fig. 1 oder Fig. 2 beschriebenen Art auf.

## Patentansprüche

1. Verfahren zum Schutz von an einen Hochfrequenzgenerator (11, 11.1, 51, 52) angeschlossenen passiven Komponenten (14, 53, 54) mit den Verfahrensschritten:
a. Erzeugen einer Hochfrequenzleistung bei einer Grundfrequenz mittels des Hochfrequenzgenerators (11, 11.1, 51, 52);
b. Übertragen der Hochfrequenzleistung an eine Last (16) über ein Hochfrequenzkabel (14, 53, 54);
c. Ermitteln einer Größe ;
d. Vergleich der ermittelten Größe mit einer Referenzgröße
e. Anpassung der vom Hochfrequenzgenerator (11, 11.1, 51, 52) bei der Grundfrequenz erzeugten Hochfrequenzleistung in Abhängigkeit von dem Vergleichsergebnis,
**dadurch gekennzeichnet, dass** die Größe eine mit der Hochfrequenzbelastung zumindest einer an den Hochfrequenzgenerator (11, 11.1, 51, 52) angeschlossenen passiven Komponente in Beziehung stehenden Größe ist und dass die Referenzgröße die maximale Belastung zumindest einer angeschlossenen passiven Komponente beschreibende Referenzgröße ist.

2. Verfahren nach Anspruch 1, **dadurch gekennzeichnet, dass** die vom Hochfrequenzgenerator (11, 11.1, 51, 52) bei der Grundfrequenz erzeugte Hochfrequenzleistung in Abhängigkeit von dem Vergleichsergebnis geregelt wird.

3. Verfahren nach einem der vorhergehenden Ansprüche, **dadurch gekennzeichnet, dass** eine mit der über das Hochfrequenzkabel (14, 53, 54) bei der Grundfrequenz übertragenen Hochfrequenzleistung in Beziehung stehende Größe ermittelt wird, die ermittelte Größe mit einem Sollwert der Hochfrequenzleistung (33) verglichen wird und die vom Hochfrequenzgenerator (11, 11.1, 51, 52) bei der Grundfrequenz erzeugte Hochfrequenzleistung in Abhängigkeit von dem Vergleichsergebnis angepasst wird.

4. Verfahren nach Anspruch 3, **dadurch gekennzeichnet, dass** für die Anpassung der vom Hochfrequenzgenerator(11, 11.1, 51, 52) bei der Grundfrequenz erzeugten Hochfrequenzleistung dasjenige Vergleichsergebnis verwendet wird, das zu einer stärkeren Reduzierung der Hochfrequenzleistung führt.

5. Verfahren nach einem der vorhergehenden Ansprüche, **dadurch gekennzeichnet, dass** die bei von der Grundfrequenz abweichenden Frequenzen über das Hochfrequenzkabel übertragene Leistung ermittelt wird.

6. Verfahren nach einem der vorhergehenden Ansprüche, **dadurch gekennzeichnet, dass** die gesamte und/oder die bei den von der Grundfrequenz abweichenden Frequenzen über das Hochfrequenzkabel (14, 54, 54) in Richtung Last (16) übertragene Leistung angezeigt wird.

7. Verfahren nach einem der vorhergehenden Ansprüche, **dadurch gekennzeichnet, dass** die Hochfrequenzbelastung mehrerer passiver Komponenten, insbesondere Hochfrequenzkabel (14, 53, 54), über die jeweils ein HF-Generator (11, 11.1, 51, 52) mit der Last (16) verbunden ist, ermittelt wird und wenn eine Hochfrequenzbelastung einen vorgegebenen Wert übersteigt die bei der jeweiligen Grundfrequenz erzeugte HF-Leistung aller an die Last (16) angeschlossener HF-Generatoren (11, 11.1, 51, 52) reduziert wird.

8. Verfahren nach einem der vorhergehenden Ansprüche, **dadurch gekennzeichnet, dass** die die maximale Belastung einer passiven Komponente beschreibende Referenzgröße eingestellt wird.

9. Hochfrequenzgenerator (11, 11.1, 51, 52) mit einer ein Hochfrequenzleistungssignal bei einer Grundfrequenz erzeugenden HF-Quelle (12) und einem ersten Regelkreis (18, 18.1), dem ein mit einer über ein Hochfrequenzkabel (14, 53, 54) zwischen dem Hochfrequenzgenerator (11, 11.1, 51, 52) und einer Last (16) übertragenen HF-Leistung in Beziehung stehendes Signal zugeführt ist, wobei der erste Regelkreis (18. 18.1) einen Regler (24) zur Regelung der HF-Quelle (12) basierend auf der übertragenen HF-Leistung aufweist, **dadurch gekennzeichnet, dass** die Regelung der HF-Quelle (12) auch basiert auf einem dem Regler (24) zugeführten Sollwert für die HF-Belastung, insbesondere HF-Kabelbelastung.

10. Hochfrequenzgenerator nach Anspruch 9, , **dadurch gekennzeichnet, dass** ein zweiter Regelkreis vorgesehen ist, dem ein mit einer über ein Hochfrequenzkabel (14, 53, 54) zwischen dem Hochfrequenzgenerator (11, 11.1, 51, 52) und der Last (16) übertragenen HF-Leistung in Beziehung stehendes Signal zugeführt ist, wobei der zweite Regelkreis einen Regler (32) zur Regelung der HF-Quelle (12) basierend auf einem Sollwert (33) für die vom Hochfrequenzgenerator (11, 11.1, 51, 52) auszugebende Hochfrequenzleistung bei der Grundfrequenz und der übertragenen HF-Leistung aufweist.

11. Hochfrequenzgenerator nach Anspruch 9 oder 10, **dadurch gekennzeichnet, dass** die Regler (24, 32) über eine Vorrangschaltung (26) mit der HF-Quelle (12) verbunden sind.

12. Hochfrequenzgenerator nach einem der vorhergehenden Ansprüche 9 bis 11, **dadurch gekennzeichnet, dass** Mittel zum Bestimmen der über das HF-Kabel (14, 53, 54) übertragenen Oberwellenleistung vorgesehen sind.

13. Hochfrequenzgenerator nach einem der vorhergehenden Ansprüche 9 bis 12, **dadurch gekennzeichnet, dass** Mittel zum Bestimmen der über das HF-Kabel (14, 53, 54) übertragenen Hochfrequenzleistung vorgesehen sind.

14. Leistungsversorgungsanordnung (10, 10.1) mit einem Hochfrequenzgenerator (11, 11.1, 51, 52) nach einem der vorhergehenden Ansprüche 9 bis 13, der über ein Hochfrequenzkabel (14, 53, 54) an eine Last (16) angeschlossen ist.

15. Leistungsversorgungsanordnung nach Anspruch 14, **dadurch gekennzeichnet, dass** zumindest ein weiterer Hochfrequenzgenerator (51, 52) über ein Hochfrequenzkabel (53, 54) an die Last angeschlossen ist.

## Claims

1. Method for protecting passive components (14, 53, 54) which are connected to a high-frequency generator (11, 11.1, 51, 52), the method comprising the following steps:
a. generating a high-frequency power at a fundamental frequency by means of the high-frequency generator (11, 11.1, 51, 52);
b. transmitting the high-frequency power to a load (16) by a high-frequency cable (14, 53, 54);
c. determining a variable
d. comparing the determined variable with a reference variable;
e. adjusting the high-frequency power, generated by the high-frequency generator (11, 11.1, 51, 52) at the fundamental frequency, on the basis of the comparison result,
**characterised in that** the variable is a variable related to the high frequency load of at least one passive component connected to the high frequency generator (11, 11.1, 51, 52), and **in that** the reference variable is a reference variable which describes the maximum load on at least one connected passive component.

2. Method according to claim 1, **characterised in that** the high-frequency power generated by the high-frequency generator (11, 11.1, 51, 52) at the fundamental frequency is controlled on the basis of the comparison result.

3. Method according to any one of the preceding claims, **characterised in that** a variable related to the high-frequency power, transmitted by the high-frequency cable (14, 53, 54) at the fundamental frequency is determined, the determined variable is compared with a set value of the high-frequency power (33) and the high-frequency power generated by the high-frequency generator (11, 11.1, 51, 52) at the fundamental frequency is matched on the basis of the comparison result.

4. Method according to claim 3, **characterised in that**, for adjusting the high-frequency power generated by the high-frequency generator (11, 11.1, 51, 52) at the fundamental frequency, that comparison result is used which produces a relatively greater reduction in the high-frequency power.

5. Method according to any one of the preceding claims, **characterised in that** the power transmitted by the high-frequency cable at frequencies different from the fundamental frequency is determined.

6. Method according to any one of the preceding claims, **characterised in that** the entire power and/or the power transmitted in the direction of the load (16) by the high-frequency cable (14, 53, 54) at the frequencies which differ from the fundamental frequency is displayed.

7. Method according to any one of the preceding claims, **characterised in that** the high-frequency load of a plurality of passive components, in particular of high-frequency cables (14, 53, 54), via each of which an HF generator (11, 11.1, 51, 52) is connected to the load (16), is determined, and if a high-frequency load exceeds a predetermined value, the HF power of all HF generators (11, 11.1, 51, 52) connected to the load (16) which is generated at the respective fundamental frequency is reduced.

8. Method according to any one of the preceding claims, **characterised in that** the reference variable describing the maximum load on a passive component is adjusted.

9. High-frequency generator (11, 11.1, 51, 52) having an HF source (12), which generates a high-frequency power signal at a fundamental frequency, and having a first control circuit (18, 18.1) which is fed with a signal related to an HF power transmitted by a high-frequency cable (14, 53, 54) between the high-frequency generator (11, 11.1, 51, 52) and a load (16), wherein the first control circuit (18, 18.1) has a controller (24) for controlling the HF source (12) based on the transmitted HF power **characterised in that** the controlling of the HF source (12) is also based on a set value for the HF load fed to the controller (24), in particular for the HF cable load.

10. High-frequency generator according to claim 9, **characterised in that** a second control circuit is provided, which is fed with a signal related to an HF power transmitted by a high-frequency cable (14, 53, 54) between the high-frequency generator (11, 11.1, 51, 52) and the load (16), wherein the second control circuit has a controller (32) for controlling the HF source (12) based on a set value (33) for the high-frequency power to be output by the high-frequency generator (11, 11.1, 51, 52) at the fundamental frequency and the transmitted HF power.

11. High-frequency generator according to either claim 9 or claim 10, **characterised in that** the controllers (24, 32) are connected to the HF source (12) by a priority circuit (26).

12. High-frequency generator according to any one of the preceding claims 9 to 11, **characterised in that** means are provided for determining the harmonic power transmitted by the HF cable (14, 53, 54).

13. High-frequency generator according to any one of the preceding claims 9 to 12, **characterised in that** means are provided for determining the high-frequency power transmitted by the HF cable (14, 53, 54).

14. Power supply arrangement (10, 10.1) having a high-frequency generator (11, 11.1, 51, 52) according to any one of the preceding claims 9 to 13, which is connected to a load (16) by a high-frequency cable (14, 53, 54).

15. Power supply arrangement according to claim 14, **characterised in that** at least one further high-frequency generator (51, 52) is connected to the load by a high-frequency cable (53, 54).

## Revendications

1. Procédé pour la protection de composants passifs (14, 53, 54) raccordés à un générateur haute fréquence (11, 11.1, 51, 52), avec les étapes suivantes du procédé :
a. génération d'une puissance haute fréquence à une fréquence de base au moyen du générateur haute fréquence (11, 11.1, 51, 52) ;
b. transmission de la puissance haute fréquence à une charge (16) via un câble haute fréquence (14, 53, 54) ;
c. détermination d'une grandeur ;
d. comparaison de la grandeur déterminée avec une grandeur de référence ;
e. adaptation de la puissance haute fréquence générée à la fréquence de base par le générateur haute fréquence (11, 11.1, 51, 52) en fonction du résultat de la comparaison,
**caractérisé en ce que** la grandeur est une grandeur en rapport avec la contrainte de haute fréquence d'au moins un composant passif raccordé au générateur haute fréquence (11, 11.1, 51, 52) et **en ce que** la grandeur de référence est la grandeur de référence décrivant la contrainte maximale d'au moins un composant passif raccordé.

2. Procédé selon la revendication 1, **caractérisé en ce que** la puissance haute fréquence générée à la fréquence de base par le générateur haute fréquence (11, 11.1, 51, 52) est régulée en fonction du résultat de la comparaison.

3. Procédé selon l'une des revendications précédentes, **caractérisé en ce que** l'on détermine une grandeur en rapport avec la puissance haute fréquence transmise à la fréquence de base via le câble haute fréquence (14, 53, 54), la grandeur déterminée étant comparée avec une valeur de consigne de la puissance haute fréquence (33), et la puissance haute fréquence générée à la fréquence de base par le générateur haute fréquence (11, 11.1, 51, 52) étant adaptée en fonction du résultat de la comparaison.

4. Procédé selon la revendication 3, **caractérisé en ce que**, pour l'adaptation de la puissance haute fréquence générée à la fréquence de base par le générateur haute fréquence (11, 11.1, 51, 52), on utilise celui des résultats de comparaison qui donne une plus forte réduction de la puissance haute fréquence.

5. Procédé selon l'une des revendications précédentes, **caractérisé en ce que** l'on détermine la puissance transmise via le câble haute fréquence à des fréquences divergeant de la fréquence de base.

6. Procédé selon l'une des revendications précédentes, **caractérisé en ce que** l'on affiche la puissance globale transmise et/ou la puissance transmise aux fréquences divergeant de la fréquence de base, via le câble haute fréquence (14, 54, 54) en direction de la charge (16).

7. Procédé selon l'une des revendications précédentes, **caractérisé en ce que** l'on détermine la contrainte de haute fréquence de plusieurs composants passifs, en particulier du câble haute fréquence (14, 53, 54), via lesquels respectivement un générateur haute fréquence (11, 11.1, 51, 52) est connecté à la charge (16), et lorsqu'une contrainte de haute fréquence dépasse une valeur prescrite, la puissance haute fréquence générée à la fréquence de base respective de tous les générateurs haute fréquence (11, 11.1, 51, 52) raccordés à la charge (16) étant réduite.

8. Procédé selon l'une des revendications précédentes, **caractérisé en ce que** l'on règle la grandeur de référence décrivant la contrainte maximale d'un composant passif.

9. Générateur haute fréquence (11, 11.1, 51, 52) avec une source de haute fréquence (12) générant un signal de puissance haute fréquence à une fréquence de base et un premier circuit de réglage (18, 18.1) auquel on amène un signal en rapport avec une puissance haute fréquence transmise via un câble haute fréquence (14, 53, 54) entre le générateur haute fréquence (11, 11.1, 51, 52) et une charge (16), le premier circuit de réglage (18. 18.1) présentant un régulateur (24) pour réguler la source de haute fréquence (12) sur la base de la puissance haute fréquence transmise,
**caractérisé en ce que** la régulation de la source de haute fréquence (12) se base également sur une valeur de consigne amenée au régulateur (24) pour la contrainte de haute fréquence, en particulier la contrainte de haute fréquence du câble.

10. Générateur haute fréquence selon la revendication 9, **caractérisé en ce que** l'on prévoit un deuxième circuit de réglage auquel on amène un signal en rapport avec une puissance haute fréquence transmise via un câble haute fréquence (14, 53, 54) entre le générateur haute fréquence (11, 11.1, 51, 52) et la charge (16), le deuxième circuit de réglage présentant un régulateur (32) pour la régulation de la source de haute fréquence (12) sur la base d'une valeur de consigne (33) pour la puissance haute fréquence à faire sortir par le générateur haute fréquence (11, 11.1, 51, 52) à la fréquence de base et de la puissance haute fréquence transmise.

11. Générateur haute fréquence selon la revendication 9 ou 10, **caractérisé en ce que** les régulateurs (24, 32) sont connectés via un circuit de priorité (26) à la source de haute fréquence (12).

12. Générateur haute fréquence selon l'une des revendications 9 à 11 précédentes, **caractérisé en ce que** l'on prévoit des moyens pour la détermination de la puissance d'onde harmonique transmise via le câble haute fréquence (14, 53, 54).

13. Générateur haute fréquence selon l'une des revendications 9 à 12 précédentes, **caractérisé en ce que** l'on prévoit des moyens pour la détermination de la puissance haute fréquence transmise via le câble haute fréquence (14, 53, 54).

14. Dispositif d'alimentation en puissance (10, 10.1) avec un générateur haute fréquence (11, 11.1, 51, 52) selon l'une des revendications 9 à 13 précédentes, lequel est raccordé via un câble haute fréquence (14, 53, 54) à une charge (16).

15. Dispositif d'alimentation en puissance selon la revendication 14, **caractérisé en ce qu'**au moins un autre générateur haute fréquence (51, 52) est raccordé via un câble haute fréquence (14, 53, 54) à la charge.
